# EUROPEAN PATENT APPLICATION

(11) **EP 2 100 990 A1**
(43) Date of publication of application: **16.09.2009**
(21) Application number: 07829477.4
(22) Date of filing: 10.10.2007
(51) Int. Cl.: C30B 29/38, C30B 7/10

(54) **PROCESS FOR PRODUCING NITRIDE SEMICONDUCTOR, CRYSTAL GROWTH RATE ENHANCEMENT AGENT, NITRIDE SINGLE CRYSTAL, WAFER AND DEVICE**

(30) Priority: 16.10.2006 JP 2006280940
(71) Applicant: Mitsubishi Chemical Corporation, Tokyo 108-0014 (JP); Tohoku University, Aoba-ku Sendai-shi Miyagi 980-8577 (JP)
(72) Inventor: KAWABATA, Shinichiro, Ushiku-shi Ibaraki 3001295 (JP); ITOH, Hirohisa, Ushiku-shi Ibaraki 3001295 (JP); EHRENTRAUT, Dirk, Sendai-shi Miyagi 9808577 (JP); KAGAMITANI, Yuji, Sendai-shi Miyagi 9808577 (JP); YOSHIKAWA, Akira, Sendai-shi Miyagi 9808577 (JP); FUKUDA, Tsuguo, Sendai-shi Miyagi 9808577 (JP)
(74) Representative: Naylor, Matthew John
(86) International application number: PCT/JP2007/069739
(87) International publication number: WO 2008/047637

(57) **Abstract**

A method for producing a nitride semiconductor, comprising controlling temperature and pressure in a autoclave containing a seed having a hexagonal crystal structure, a nitrogen element-containing solvent, a raw material substance containing a metal element of Group 13 of the Periodic Table, and a mineralizer so as to put said solvent into a supercritical state and/or a subcritical state and thereby ammonothermally grow a nitride semiconductor crystal on the surface of said seed, wherein the crystal growth rate in the m-axis direction on said seed is 1.5 times or more the crystal growth rate in the c-axis direction on said seed. By the method, a nitride semiconductor having a large-diameter C plane or a nitride semiconductor thick in the m-axis direction can be efficiently and simply produced.

## Description

### TECHNICAL FIELD

The present invention relates to a production method of a nitride semiconductor, where the crystal growth of a nitride semiconductor on a seed is performed by using a solvent in a supercritical state and/or a subcritical state together with a raw material substance and a mineralizer, and a crystal growth rate increasing agent for use in the production method. The present invention also relates to a single crystal nitride produced by the method, a wafer and a device.

### BACKGROUND ART

A nitride semiconductor as typified by gallium nitride (GaN) is useful as a substance applied to a light-emitting device such as light-emitting diode and laser diode or to a high-frequency and/or high-output electronic device such as HEMT and HBT. Particularly, in usage for an electronic device expected to expand its market in the future, the device size is larger than that of a light-emitting device and in view of productivity, formation of a large-diameter wafer is more keenly demanded. Furthermore, high uniformity of the crystal quality in the large-diameter wafer plane is required.

At present, the gallium nitride crystal is produced by vapor phase epitaxial growth such as MOCVD (metal-organic chemical vapor deposition) on a substrate such as sapphire or silicon carbide. At this time, the production is generally performed using a C-plane substrate having polarity. However, the diameter of the growing crystal is defined by the size of the substrate and therefore, the method above allows production of only a crystal or wafer having the same diameter as that of the substrate. Also, in the vapor phase epitaxial method, a large-diameter crystal cannot be produced in view of technique, because it is difficult to uniformly expose a raw material in a large area.

On the other hand, it is recently reported that the device properties can be remarkably improved by using a nonpolar face substrate such as M plane instead of using a C plane (see, Non-Patent Document 1). Also, there are techniques where the crystal growth using an M-plane substrate is proposed (see, Patent Documents 1 to 3). However, in the heteroepitaxial growth method on a substrate such as sapphire or silicon carbide by the MOCVD method or the like, which is being performed at present, a high-quality and large-diameter M plane can be hardly grown. Therefore, in order to obtain a high-quality M-plane wafer, a technique for cutting an M-plane wafer from a bulk single crystal gallium nitride is demanded. However, in the bulk single crystal gallium nitride, the diameter of the M plane is small, and the wafer which can be cut out from the bulk single crystal gallium nitride is only a small-diameter M-plane wafer.

For obtaining a single crystal gallium nitride having a large-diameter C plane or a single crystal gallium nitride thick in the m-axis direction, crystal growth in the direction perpendicular to the c-axis is necessary. As for the crystal growth in the direction perpendicular to the c-axis, several studies or proposals have been heretofore made.

For example, it is reported that in the basic mineralizer system, the crystal growth rate in the a-axis direction perpendicular to the c-axis is faster than the crystal growth rate in the c-axis direction (see, Patent Documents 4 and 5). However, in these publications, specific methods and results are not disclosed. Also, in the first place, because this is an ammonothermal method using a basic mineralizer, there are problems such as mixing of an alkali metal impurity which becomes an obstacle to the device production, need for high temperature and high pressure, and unusability of a noble metal as a pressure vessel liner for preventing mixing of impurities, and this technique has many obstacles to practical use. Furthermore, in a hexagonal wurtzite-type crystal structure, M plane is more stable than A plane, and thus, when a crystal is grown in the a-axis direction from A plane, stable M plane is produced to make the crystal growth plane into a chevron shape, and a flat crystal plane having a large area cannot be grown.

As for the crystal growth in an axial direction other than the a-axis, there is reported a case where a crystal is grown also in the m-axis direction perpendicular to the c-axis by an ammonothermal method that is a representative technique for obtaining a bulk single crystal gallium nitride (see, Non-Patent Document 2). However, the growth rate in the m-axis direction is almost the same as the growth rate in the c-axis direction, and a production method of a bulk single crystal gallium nitride, where the growth rate in the m-axis direction becomes significantly large, has not been heretofore reported.
Non-Patent Document 1: Japanese Journal of Applied Physics, Vol. 44, No. 5, pp. L173-L175 (2005)
Non-Patent Document 2: Journal of Crystal Growth, 287, 376-380 (2006)
Patent Document 1: JP-A-2005-506271 (the term "JP-A" as used herein means an "unexamined published Japanese patent application")
Patent Document 2: JP-A-2003-43150
Patent Document 3: JP-A-2003-36771
Patent Document 4: JP-T-2006-509709 (the term "JP-T" as used herein means a "published Japanese translation of a PCT patent application")
Patent Document 5: JP-T-2006-509710

### DISCLOSURE OF THE INVENTION

### PROBLEMS THAT THE INVENTION IS TO SOLVE

In this way, a practical and effective method for accelerating the crystal growth in a direction perpendicular to the c-axis has not been conventionally present. For this reason, despite the need to obtain a wafer having a large-diameter C plane, development of a practical and simple production method therefor has not been achieved.
Also, for obtaining a wafer having a large M plane, a method of cutting out an M-plane wafer from a bulk single crystal gallium nitride obtained by growing the crystal in the c-axis direction by a technique such as ammonothermal method is employed, but in this method, the growth rate differs between C+ plane and C- plane, giving rise to a problem that the C+ plane growth part and the C- plane growth part, which correspond to two end planes of a crystal obtained, differ in the impurity concentration and the number of crystal defects, and a wafer having a uniform quality in the M plane cannot be obtained.

In consideration of these problems of conventional techniques, the present inventors set as an object of the present invention to provide a practical production method capable of efficiently and simply producing a nitride semiconductor having a large-diameter C plane or a nitride semiconductor thick in the m-axis direction. Also, the present inventors set as another object of the present invention to accelerate the crystal growth of such a nitride semiconductor. Furthermore, the present inventors set as still another object of the present invention to provide a single crystal nitride with uniform and excellent quality, and a wafer and a device each using the single crystal nitride.

### MEANS FOR SOLVING THE PROBLEMS

As a result of intensive studies, the present inventors have developed for the first time a crystal growth method where the crystal growth rate in the m-axis direction is significantly higher than in the c-axis direction, and it has been found that when crystal growth is performed according to this method, the above-described problems can be solved and the objects of the present invention can be achieved. That is, the present invention provides the following techniques as means for solving the problems.

[1] A method for producing a nitride semiconductor, comprising controlling temperature and pressure in a reaction vessel containing a seed having a hexagonal crystal structure, a nitrogen element-containing solvent, a raw material substance containing a metal element of Group 13 of the Periodic Table, and a mineralizer so as to put the solvent into a supercritical state and/or a subcritical state and thereby ammonothermally grow a nitride semiconductor crystal on the surface of the seed, wherein the crystal growth rate in the m-axis direction on the seed is 1.5 times or more the crystal growth rate in the c-axis direction on the seed.

[2] The method for producing a nitride semiconductor as described in [1], wherein the crystal growth rate in the m-axis direction on the seed is 2.0 times or more the crystal growth rate in the c-axis direction on the seed.
[3] The method for producing a nitride semiconductor as described in [1] or [2], wherein the temperature is from 250 to 490°C.
[4] The method for producing a nitride semiconductor as described in any one of [1] to [3], wherein the pressure is from 60 to 160 MPa.
[5] The method for producing a nitride semiconductor as described in any one of [1] to [4], wherein the raw material substance contains a polycrystalline gallium nitride and/or gallium.
[6] The method for producing a nitride semiconductor as described in [5], wherein the nitride semiconductor is a gallium-containing nitride semiconductor.
[7] The method for producing a nitride semiconductor as described in [5], wherein the nitride semiconductor is a gallium nitride crystal.

[8] The method for producing a nitride semiconductor as described in any one of [1] to [7], wherein the mineralizer contains an acidic mineralizer.
[9] The method for producing a nitride semiconductor as described in [8], wherein the acidic mineralizer contains an ammonium salt.
[10] The method for producing a nitride semiconductor as described in [8], wherein the acidic mineralizer contains an ammonium halide.
[11] The method for producing a nitride semiconductor as described in any one of [1] to [10], wherein the mineralizer contains a mineralizer containing an alkali metal element or an alkaline earth metal element.
[12] The method for producing a nitride semiconductor as described in [11], wherein the mineralizer containing an alkali metal element or an alkaline earth metal element contains a magnesium halide and/or a calcium halide.
[13] The method for producing a nitride semiconductor as described in any one of [1] to [12], wherein a plurality of chemical species are mixed as the mineralizer.
[14] The method for producing a nitride semiconductor as described in any one of [1] to [13], wherein one or more chemical species selected from the group consisting of an ammonium salt, a magnesium salt and a calcium salt are used as the mineralizer.
[15] The method for producing a nitride semiconductor as described in any one of [1] to [14], wherein at least a part of the inner wall of the reaction vessel is composed of a noble metal.
[16] The method for producing a nitride semiconductor as described in any one of [1] to [15], wherein a seed having a hexagonal crystal structure with the area of an M plane being larger than the area of a C plane is used as the seed.
[17] The method for producing a nitride semiconductor as described in any one of [1] to [16], wherein a seed having a cleavage plane is used as the seed and a nitride semiconductor is ammonothermally grown on the cleavage plane.

[18] A method for producing a nitride semiconductor, comprising controlling temperature and pressure in a reaction vessel containing a seed having a hexagonal crystal structure, a nitrogen element-containing solvent, a raw material substance containing a metal element of Group 13 of the Periodic Table, and a mineralizer composed of a plurality of chemical species, so as to put the solvent into a supercritical state and/or a subcritical state and thereby ammonothermally grow a nitride semiconductor crystal on the surface of the seed.
[19] The method for producing a nitride semiconductor as described in [18], wherein the temperature is from 250 to 490°C.
[20] The method for producing a nitride semiconductor as described in [18] or [19], wherein the pressure is from 60 to 160 MPa.
[21] The method for producing a nitride semiconductor as described in any one of [18] to [20], wherein the raw material substance contains a polycrystalline gallium nitride and/or gallium.
[22] The method for producing a nitride semiconductor as described in [21], wherein the nitride semiconductor is a gallium-containing nitride semiconductor.
[23] The method for producing a nitride semiconductor as described in [21], wherein the nitride semiconductor is a gallium nitride crystal.
[24] The method for producing a nitride semiconductor as described in any one of [18] to [23], wherein the mineralizer is an acidic mineralizer.
[25] The method for producing a nitride semiconductor as described in [24], wherein the acidic mineralizer contains an ammonium salt.
[26] The method for producing a nitride semiconductor as described in [24], wherein the acidic mineralizer contains an ammonium halide.
[27] The method for producing a nitride semiconductor as described in any one of [18] to [26], wherein the mineralizer contains a mineralizer containing an alkali metal element or an alkaline earth metal element.
[28] The method for producing a nitride semiconductor as described in [27], wherein the mineralizer containing an alkali metal element or an alkaline earth metal element contains a magnesium halide and/or a calcium halide.
[29] The method for producing a nitride semiconductor as described in any one of [18] to [28], wherein two kinds of chemical species are mixed as the mineralizer.
[30] The method for producing a nitride semiconductor as described in any one of [18] to [29], wherein two or more chemical species selected from the group consisting of an ammonium salt, a magnesium salt and a calcium salt are used as the mineralizer.
[31] The method for producing a nitride semiconductor as described in any one of [18] to [30], wherein at least a part of the inner wall of the reaction vessel is composed of a noble metal.
[32] The method for producing a nitride semiconductor as described in any one of [18] to [31], wherein a seed having a hexagonal crystal structure with the area of an M plane being larger than the area of a C plane is used as the seed.
[33] The method for producing a nitride semiconductor as described in any one of [18] to [32], wherein a seed having a cleavage plane is used as the seed and a nitride semiconductor is ammonothermally grown on the cleavage plane.
[34] A growth rate increasing agent, which is a crystal growth rate increasing agent used when controlling temperature and pressure in a reaction vessel containing a seed having a hexagonal crystal structure, a nitrogen element-containing solvent, a raw material substance containing a metal element of Group 13 of the Periodic Table, and a mineralizer so as to put the solvent into a supercritical state and/or a subcritical state and thereby ammonothermally grow a nitride semiconductor crystal on the surface of the seed, the growth rate increasing agent containing a mineralizer composed of a plurality of chemical species.
[35] The crystal growth rate increasing agent as described in [34], wherein the temperature is from 250 to 490°C.
[36] The crystal growth rate increasing agent as described in [34] or [35], wherein the pressure is from 60 to 160 MPa.
[37] A single crystal nitride produced by the method described in any one of [1] to [33].
[38] The single crystal nitride as described in [37], wherein the surface area of an M plane is larger than the surface area of a C plane.
[39] A wafer cut out from the single crystal nitride described in [37] or [38].
[40] An epitaxial wafer using the wafer described in [39] as the substrate.
[41] A device using the single crystal nitride described in [37] or [38], the wafer described in [39], or the epitaxial wafer described in [40].

### ADVANTAGE OF THE INVENTION

According to the production method of the present invention, a nitride semiconductor having a large-diameter C plane or a nitride semiconductor thick in the m-axis direction can be efficiently and simply produced. Also, according to the growth rate increasing agent of the present invention, the growth rate of a nitride semiconductor can be significantly increased. Furthermore, the single crystal nitride of the present invention has a uniform and excellent quality. Therefore, the wafer and device of the present invention, each using such an excellent single crystal nitride, exhibit high performance.

### BRIEF DESCRIPTION OF THE DRAWINGS

Fig. 1 is a view for explaining the axis and plane of a hexagonal crystal structure.
Fig. 2 is a schematic cross-sectional view of a crystal production apparatus by a solvothermal method used in Examples.
In the Figure, 1 is a valve, 2 is a pressure gauge, 3 is an autoclave, 4 is a crystal growth part, 5 is a raw material filling part, 6 is a baffle plate, 7 is an electric furnace, 8 is a thermocouple, 9 is a raw material, 10 is a seed, and 11 is a channel.

### BEST MODE FOR CARRYING OUT THE INVENTION

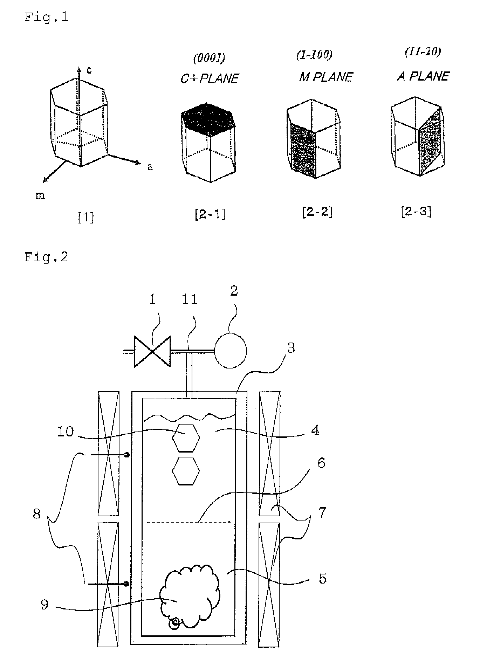

The production method of a nitride semiconductor of the present invention is described in detail below. In the following, the construction requirements are described based on representative embodiments of the present invention, but the present invention is not limited to these embodiments. Incidentally, the c-axis, m-axis and a-axis as used for describing a hexagonal crystal structure in the context of the present invention each indicate an axial direction shown in [1] of Fig. 1, the C plane indicates a (0001) plane shown in [2-1] of Fig. 1 <in the Figure, a C+ plane is illustrated>, the M plane indicates a (1-100) plane shown in [2-2] of Fig. 1, and the A plane indicates a (1-120) plane shown in [2-3] of Fig. 1. Also, the numerical value range expressed using "from (numerical value) to (numerical value)" means a range including the numerical values before and after "to" as a lower limit or an upper limit.

### (Characteristic Feature of the Present Invention)

The production method of a nitride semiconductor or the present invention comprises controlling the temperature and pressure in a reaction vessel containing a seed having a hexagonal crystal structure, a nitrogen element-containing solvent, a raw material substance containing a metal element of Group 13 of the Periodic Table, and a mineralizer so as to put the solvent into a supercritical state and/or a subcritical state and thereby ammonothermally grow a nitride semiconductor crystal on the surface of the seed. The characteristic feature thereof resides in that the crystal growth rate in the m-axis direction on the seed is 1.5 times or more, preferably 1.8 times or more, more preferably 2.0 times or more, still more preferably 2.1 times or more, yet still more preferably 2.4 times or more, the crystal growth rate in the c-axis direction on the seed. In another aspect of the present invention, the characteristic feature of the present invention resides in using a mineralizer composed of a plurality of chemical species.

In order to raise the crystal growth rate in the m-axis direction on the seed to 1.5 times or more the crystal growth rate in the c-axis direction on the seed, for example, the temperature and/or pressure at the crystal growth are preferably reduced to fall in a predetermined range. Specifically, the temperature at the crystal growth is set to 250 to 490°C and/or the pressure at the crystal growth is set to 60 to 160 MPa, whereby the crystal growth rate in the m-axis direction can be made to be 1.5 times or more the crystal growth rate in the c-axis direction. At this time, an acidic mineralizer is preferably used as the mineralizer, because mixing of an alkali metal impurity that becomes an obstacle to the device production can be prevented and the nitride semiconductor can be produced using a reaction vessel in which the inner wall uses a noble metal. Also, when a mineralizer composed by combining a plurality of chemical species (in particular, an acidic mineralizer composed by combining a plurality of chemical species) is used, the solubility of a raw material in a solvent and in turn, the crystal growth rate can be raised and this is more preferred.

The present inventors have worked on a new theme of accelerating the crystal growth in the m-axis direction and made studies for the first time by taking notice of the relative relationship between the growth rate in the c-axis direction and the growth rate in the m-axis direction, and as a result, the present invention have been accomplished. In the production method of the present invention, a single crystal nitride having a desired shape that fulfills the object of the present invention can be obtained by appropriately selecting the shape of the seed and the production method. Accordingly, a nitride semiconductor having a large-diameter C plane or a nitride semiconductor thick in the m-axis direction can be efficiently produced. The obtained nitride semiconductor is characterized by a uniform quality, because the crystal quality is equal in the growth parts on both sides of the crystal. In particular, when the crystal is ammonothermally grown on an M plane produced by cleavage, a higher-quality crystal or wafer can be obtained at a higher growth rate. Therefore, according to the present invention, a uniform and high-quality wafer can be obtained as compared with an M-plane wafer cut out from a bulk single crystal gallium nitride obtained by growing the crystal in the c-axis direction by a conventional method.

### (Materials Used)

In the present invention, a nitrogen element-containing solvent is used as the solvent. The nitrogen element-containing solvent includes a solvent that does not impair the stability of single crystal nitride grown, and specific examples thereof include ammonia, hydrazine, urea, amines (for example, a primary amine such as methylamine, a secondary amine such as dimethylamine, a tertiary amine such as trimethylamine, and a diamine such as ethylenediamine), and melamine. One of these solvents may be used alone, or a mixture thereof may be used.

The amount of water or oxygen contained in the solvent for use in the present invention is preferably as small as possible, and the content thereof is preferably 1,000 ppm or less, more preferably 10 ppm or less, still more preferably 0. 1 ppm or less. In the case of using ammonia as the solvent, the purity thereof is usually 99.9% or more, preferably 99.99% or more, more preferably 99.999% or more, still more preferably 99.9999% or more.

The mineralizer for use in the production method of the present invention is a compound that raises the solubility of a raw material in the solvent. In order not to allow the grown crystal to contain an oxygen element, a compound containing a nitrogen element in the form of an ammonium ion (ammonium salt) or an amide is preferably used as at least one chemical species constituting the mineralizer, and a compound containing a nitrogen element in the form of an ammonium ion (ammonium salt) is more preferred.

In the present invention, for preventing an impurity from mixing in the grown single crystal nitride, the mineralizer is purified and dried, if desired, before use. The purity of the mineralizer for use in the present invention is usually 95% or more, preferably 99% or more, more preferably 99.99% or more. The amount of water or oxygen contained in the mineralizer is preferably as small as possible, and the content thereof is preferably 1,000 ppm or less, more preferably 10 ppm or less, still more preferably 1.0 ppm or less.

In the present invention, an acidic mineralizer is preferably used. When an acidic mineralizer is used, the growth in the m-axis direction can be more accelerated under low-temperature low-pressure conditions. The acidic mineralizer also has an effect of raising the solubility of a Group 13 nitride crystal raw material in an ammonia solvent in a supercritical state and decreasing the suitable reaction pressure. Furthermore, the acidic mineralizer has an advantageous characteristic feature that the reactivity with a noble metal such as Pt constituting the inner wall of a reaction vessel is low. The acidic mineralizer includes a compound containing a halogen element, such as ammonium halide, and specific examples thereof include ammonium chloride, ammonium iodide, ammonium bromide and ammonium fluoride, with ammonium chloride being preferred.
In the present invention, a mineralizer containing an alkali metal element or an alkaline earth metal element may also be used. Examples thereof include a magnesium halide such as MgCl₂ and MgBr₂, a calcium halide such as CaCl₂ and CaBr₂, an alkali metal amide such as NaNH₂, KNH₂ and LiNH₂, a sodium halide such as NaCl and NaBr, a potassium halide such as KCl and KBr, a cesium halide such as CsCl and CsBr, and a lithium halide such as LiCl and LiBr.

In the present invention, as the mineralizer, only one kind of a chemical species may be selected and used, or two or more kinds of chemical species may be used in combination. In the present invention, it is preferred to use a mineralizer composed of two or more kinds of chemical species. By appropriately adjusting the kinds of chemical species combined or the mixing ratio of the chemical species, the crystal growth rate may be accelerated or the ratio (m-axis/c-axis) of the crystal growth rate in the m-axis direction to the crystal growth rate in the c-axis direction may be increased.

In the present invention, an acidic mineralizer composed by combining a plurality of chemical species is preferably used. In particular, although the solubility of a raw material such as gallium nitride in a supercritical ammonia solvent and in turn, the crystal growth rate decrease under low-temperature low-pressure conditions, when an acidic mineralizer composed by combining a plurality of chemical species is used, the solubility of a raw material in the solvent can be raised and the crystal growth rate can be accelerated. Above all, in the case of an ammonium halide mineralizer (NH₁X), for example, an ammonium halide mineralizer containing Br or I having higher reactivity (NH₄Br, NH₄I) is mixed with NH₄Cl, whereby the solubility of gallium nitride in a supercritical ammonia solvent can be enhanced.
In the present invention, it is also preferred that an acidic mineralizer and a mineralizer containing an alkali metal element or an alkaline earth metal element are used in combination. In the case of using in combination an acidic mineralizer and a mineralizer containing an alkali metal element or an alkaline earth metal element, the amount of the acidic mineralizer used is preferably larger. Specifically, the proportion of the mineralizer containing an alkali metal element or an alkaline earth metal element is preferably 50 to 0.01 parts by weight, more preferably from 20 to 0.1 parts by weight, more preferably from 5 to 0.2 parts by weight, per 100 parts by weight of the acidic mineralizer. By the addition of a mineralizer containing an alkali metal element or an alkaline earth metal element, the ratio (m-axis/c-axis) of the crystal growth rate in the m-axis direction to the crystal growth rate in the c-axis direction can also be made larger.

In the present invention, one or more (preferably two or more) chemical species selected from the group consisting of an ammonium salt, a magnesium salt and a calcium salt are preferably used as the mineralizer, and it is more preferred that one or more (preferably two or more) chemical species selected from the group consisting of an ammonium salt and a magnesium salt are used as the mineralizer.
Incidentally, at the time of performing the crystal growth of the present invention, an aluminum halide, a phosphorus halide, a silicon halide, a germanium halide, an arsenic halide, a tin halide, an antimony halide, a bismuth halide or the like may be allowed to be present in the reaction vessel.

The mineralizer and the raw material substance containing a metal element of Group 13 of the Periodic Table are used in a ratio such that the ratio of mineralizer/metal element of Group 13 of the Periodic Table (by mol) becomes usually from 0.0001 to 100, and in the case of GaN, the ratio of mineralizer/Ga (by mol) becomes usually from 0.001 to 20. The ratio used may be appropriately determined by taking into consideration, for example, the kind of the raw material, mineralizer or the like, or the size of the objective crystal.

In the present invention, a raw material containing a metal of Group 13 of the Periodic Table is used. The raw material is preferably a polycrystalline raw material of a Group 13 nitride crystal and/or gallium, more preferably gallium nitride and/or gallium. The polycrystalline raw material need not be a complete nitride and depending on the conditions, a metal component where the Group 13 element is in a metal state (zero valence) may be contained, and in the case where the crystal is gallium nitride, examples of the raw material include a mixture of gallium nitride and metal gallium.

The production method of the polycrystalline raw material used as a raw material in the present invention is not particularly limited, and, for example, a polycrystalline nitride produced by reacting a metal or an oxide or hydroxide thereof with ammonia in a reaction vessel into which an ammonia gas is flowed, may be used. Also, for example, a halide, an amide compound, an imide compound or a compound having a covalent M-N bond, such as gallazane, may be used as a metal compound raw material having higher reactivity. Furthermore, a polycrystalline nitride produced by reacting a metal such as Ga with nitrogen at high temperature under high pressure may also be used.

The amount of water or oxygen contained in the polycrystalline raw material used as a raw material in the present invention is preferably as small as possible. The oxygen content in the polycrystalline raw material is usually 1.0 mass% or less, preferably 0. 1 mass% or less, more preferably 0.0001 mass% or less. Easy mixability of oxygen in the polycrystalline raw material is related to the reactivity with water or the water absorption ability. As the crystallinity of the polycrystalline raw material is worse, a larger number of active groups such as NH group are present on the surface and may react with water to partially produce an oxide or a hydroxide. Therefore, usually, a polycrystalline raw material having as high crystallinity as possible is preferably used. The crystallinity can be estimated by the full width at half maximum (FWHM) of powder X-ray diffraction, and the half-width of the diffraction line (in the case of hexagonal gallium nitride, 2θ = about 32.5°) of (100) is usually 0.25° or less, preferably 0.20° or less, more preferably 0.17° or less.

In the present invention, a seed is used. The seed is preferably a single crystal nitride grown by the production method of the present invention but need not necessarily be the same nitride. However, in this case, it is necessary to use a seed having lattice constant and crystal lattice size parameters matching or fitting the objective nitride or a seed composed of single crystal material or polycrystalline material pieces coordinated to guarantee heteroepitaxy (that is, coincidence of crystallographic sites of atoms). Specific examples of the seed include, in the case of growing gallium nitride (GaN), single crystal GaN, single crystal nitride such as aluminum nitride (AlN) , single crystal zinc oxide (ZnO), and single crystal silicon carbide (SiC).

The seed can be determined by taking into consideration the solubility in the solvent and the reactivity with the mineralizer. As regards the seed of GaN, there may be used, for example, a single crystal obtained by separating it after epitaxially growing the crystal on a dissimilar substrate such as sapphire by an MOCVD method or an HVPE method, a single crystal obtained by growing the crystal from a metal Ga with use of Na, Li or Bi as a flux, a homo/heteroepitaxially grown single crystal obtained by using an LPE method, a single crystal produced based on a solution growth method including the method of the present invention, or a crystal obtained by cutting such a single crystal.

In the present invention, the crystal is preferably grown using a seed having an M plane produced by cleavage. When a seed having an M plane produced by cleavage is used, a high-quality semiconductor can be produced at a high growth rate as compared with the case of growing a crystal by using a seed having an unpolished M plane or a seed having a precision-polished M plane.

### (Reaction Vessel)

The production method of the present invention is performed in a reaction vessel.
The reaction vessel for use in the present invention is selected from those capable of enduring high-temperature high-pressure conditions when growing a single crystal nitride. The reaction vessel may be a reaction vessel equipped with a mechanism of adjusting the pressure applied to the reaction vessel and the contents thereof from the outside of the reaction vessel as described in JP-T-2003-511326 (International Publication No. 01/024921, pamphlet) or JP-T-2007-509507 (International Publication No. 2005/043638, pamphlet) or may be an autoclave not having such a mechanism.
The reaction vessel for use in the present invention is preferably composed of a material having pressure resistance and erosion resistance, and in particular, it is preferred to use an Ni-based alloy excellent in the erosion resistance against the solvent such as ammonia, or a Co-based alloy such as Stellite (registered trademark of Deloro Stellite Company Inc.). An Ni-based alloy is more preferred. Specific examples thereof include Inconel 625 (Inconel is a registered trademark of Huntington Alloys Canada Ltd., hereinafter the same), Nimonic 90 (Nimonic is a registered trademark of Special Metals Wiggin Ltd., hereinafter the same), and RENE 41.

The compositional ratio of such an alloy may be appropriately selected according to the temperature and pressure conditions of the solvent in the system, the reactivity and/or oxidizing power and reducing power with the mineralizer and a reaction product thereof contained in the system, and the pH condition. In the case of using such an alloy as a material constituting the inner face of the reaction vessel, the reaction vessel itself may be produced using the alloy, a thin film of the alloy may be formed as an inner cylinder and disposed inside of the reaction vessel, or an inner face of an arbitrary reaction vessel material may be plated by the alloy.

For more enhancing the erosion resistance of the reaction vessel, the inner surface of the reaction vessel may be lined or coated with a noble metal by utilizing excellent erosion resistance of the noble metal. Also, a noble metal may be used as the construction material of the reaction vessel. The noble metal as used herein includes Pt, Au, Ir, Ru, Rh, Pd, Ag, and an alloy comprising such a noble metal as the main component. Above all, Pt having excellent erosion resistance is preferably used.

Fig. 2 shows a specific example of the crystal production apparatus containing a reaction vessel, which can be used in the production method of the present invention. In this example, an autoclave is used as the reaction vessel. In the Figure, 1 is a valve, 2 is a pressure gauge, 3 is an autoclave, 4 is a crystal growth part, 5 is a raw material filling part, 6 is a baffle plate, 7 is an electric furnace, 8 is a thermocouple, 9 is a raw material, 10 is a seed, and 11 is a channel.

The baffle plate 6 is used as a partition between the crystal growth part 4 and the raw material filling part 5 and preferably has an opening ratio of 2 to 20%, more preferably from 3 to 10%. The construction material of the surface of the baffle plate is preferably the same as the material of the reaction vessel. Also, for imparting higher erosion resistance and growing a crystal with higher purity, the surface of the baffle plate is preferably composed of Ni, Ta, Ti, Nb, Pd, Pt, Au, Ir or pBN, more preferably Pd, Pt, Au, Ir or pBN, still more preferably Pt.

As regards the valve 1, pressure gauge 2 and channel 11, at least the surface is also preferably composed of an erosion-resistant material. The material is, for example, SUS316 (JIS), and use of Inconel 625 is more preferred. Incidentally, in the crystal production apparatus used when practicing the production method of the present invention, a valve, a pressure gauge and a channel need not be necessarily provided.

### (Production Process)

In practicing the production method of the present invention, a seed, a nitrogen element-containing solvent, a raw material substance containing a metal element of Group 13 of the Periodic Table, and a mineralizer are first charged into the reaction vessel, and the reaction vessel is tightly sealed. In advance of introducing these materials into the reaction vessel, the inside of the reaction vessel may be deaerated. Also, during the introduction of the materials, an inert gas such as nitrogen gas may be flowed.

The seed is usually loaded in the reaction vessel simultaneously with or after the filling of the raw material substance containing a metal element of Group 13 of the Periodic Table and the mineralizer. The seed is preferably fixed to a jig made of the same noble metal as the noble metal constituting the inner surface of the reaction vessel. After the loading, the inside may be heated and deaerated, if desired.

In a supercritical state, the viscosity is generally low and the metal element more easily diffuses than a liquid but has the same solvation force as a liquid. The subcritical state means a state of a liquid having a density almost, equal to a critical density in the vicinity of a critical temperature. For example, crystal growth utilizing the difference in the solubility of the raw material between the supercritical state and the subcritical state may also be possible by dissolving the raw material in a supercritical state in the raw material filling part and changing the temperature to create a subcritical state in the crystal growth part.

In the case of laying the system in a supercritical state, the reaction mixture is generally kept at a temperature higher than the critical point of the solvent. In the case where an ammonia solvent is used, the critical point is at a critical temperature of 132°C and a critical pressure of 11.35 MPa, but when the filling ratio to the volume of the reaction vessel is high, the pressure becomes by far higher than the critical pressure even at a temperature lower than the critical temperature. In the present invention, the "supercritical state" includes such a state exceeding the critical pressure. The reaction mixture is sealed in the reaction vessel having a constant volume and therefore, the temperature rise causes an increase in the fluid pressure. In general, when T>Tc (critical temperature of one solvent) and P>Pc (critical pressure of one solvent), the fluid is in a supercritical state.

Under the supercritical condition, a sufficiently high growth rate of single crystal nitride is obtained. The reaction time depends particularly on the reactivity and thermodynamic parameter of the mineralizer, that is, the numerical values of temperature and pressure. During the synthesis or growth of a single crystal nitride, the inside of the reaction pressure is preferably kept at a pressure of approximately from 60 to 130 MPa. The pressure is appropriately determined according to the temperature and the filling ratio of the solvent volume to the volume of the reaction vessel. Originally, the pressure inside of the reaction vessel is indiscriminately determined by the temperature and the filling ratio but in practice, slightly differs according to the raw material, the additive such as mineralizer, the non-uniformity of temperature in the reaction vessel, and the presence of dead volume.

As for the temperature range in the reaction vessel, the lower limit is usually 250°C or more, preferably 300°C or more, more preferably 350°C or more, and the upper limit is preferably 490°C or less, more preferably 450°C or less, still more preferably 425°C or less, yet still more preferably 400°C or less. Also, as for the pressure range in the reaction vessel, the lower limit is usually 60 MPa or more, preferably 70 MPa or more, more preferably 80 MPa or more, and the upper limit is preferably 160 MPa or less, more preferably 130 MPa or less, still more preferably 120 MPa or less, yet still more preferably 110 MPa or less. Incidentally, the optimal temperature or pressure can be appropriately determined according to the kind, amount or the like of the mineralizer or additive used at the crystal growth. A more preferred combination of upper limits of pressure and temperature is 450°C or less and 130 MPa or less, and a more preferred combination of pressure and temperature ranges is from 250 to 450°C and from 60 to 160 MPa.

The ratio of the solvent filled in the reaction vessel for achieving the above-described temperature range and pressure range of the reaction vessel, that is, the filling ratio, is usually from 20 to 95%, preferably from 30 to 80%, more preferably from 40 to 70%, based on the liquid density at the boiling point of the solvent of the free volume of the reaction vessel, that is, in the case of using a polycrystalline raw material and a seed crystal in the reaction vessel, the volume remaining after subtracting the volumes of the seed crystal and a structure used to place the seed crystal therein from the volume of the reaction vessel, or in the case of disposing a baffle plate, the volume remaining after further subtracting the volume of the baffle plate from the volume of the reaction vessel.

The growth of single crystal nitride in the reaction vessel is performed by heating the reaction vessel, for example, by means of an electric furnace having a thermocouple to raise the temperature and thereby maintain the inside of the reaction vessel in a subcritical state or supercritical state of the solvent such as ammonia. The heating method and the temperature rise rate to a predetermined reaction temperature are not particularly limited, but the heating is usually performed for from several hours to several days. If desired, the temperature may be raised in multiple stages or the temperature rising speed may be varied based on temperature region. Also, the heating may be performed while partially cooling the system.

Incidentally, the "reaction temperature" above is measured by the thermocouple provided to come into contact with the outer face of the reaction vessel and may be approximated to the internal temperature of the reaction vessel.

The reaction time after reaching a predetermined temperature slightly differs depending on the kind of the single crystal nitride, the kind of the raw material or mineralizer used, or the size or amount of the crystal produced but may be usually from several hours to several hundreds of days. During the reaction, the reaction temperature may be kept constant or may be gradually raised or lowered. After the reaction time for producing a desired crystal has passed, the temperature is lowered, The temperature lowering method is not particularly limited, but the reaction vessel may be allowed to cool while being kept disposed in the furnace after stopping the heating of the heater, or the reaction vessel may be taken out from the electric furnace and air-cooled. If desired, rapid cooling with use of a coolant is also suitably used.

After the temperature of the outer face of the reaction vessel or the presumed temperature inside of the reaction vessel is lowered to a predetermined temperature or less, the reaction vessel is opened. The predetermined temperature here is not particularly limited and is usually from -80°C to 200°C, preferably from -33°C to 100°C. At this time, in a state where a pipe is connected to the pipe connection port of the valve attached to the reaction vessel and is operated to communicate with a vessel filled with water or the like, the valve may be opened.
Furthermore, if desired, after the ammonia solvent in the reaction vessel is thoroughly removed, for example, by creating a vacuum state and the reaction vessel is dried and opened by putting off the cover or the like, the produced nitride crystal, unreacted raw material and additive such as mineralizer may be taken out.

In this way, a single crystal nitride can be produced by the production method of the present invention, In order to produce a single crystal nitride having a desired crystal structure, the production conditions need to be appropriately adjusted.

### (Single Crystal Nitride)

The single crystal nitride produced by accelerating the growth in the m-axis direction according to the production method of the present invention has a property that the crystal quality is equal in the growth parts on both sides of the crystal and the crystal is a uniform and high-quality crystal. In particular, when the crystal is grown according to the production method of the present invention on an M plane produced by cleavage, a higher-quality single crystal nitride can be obtained at a higher growth rate as compared with the case of growing a crystal on a precision-polished M plane.

Also, by appropriately selecting the shape of the seed used in practicing the production method of the present invention, a single crystal nitride having a desired shape can be obtained. For example, when the crystal growth of the present invention is performed using a seed having a C plane, a single crystal gallium nitride having a large-diameter C plane can be obtained with good production efficiency. Specifically, a single crystal gallium nitride having a C-plane area of preferably 1 cm² or more, more preferably 5 cm² or more, still more preferably 10 cm² or more, can be obtained. In another example, the crystal growth of the present invention is performed using a seed having an M plane, whereby a single crystal nitride thick in the m-axis direction can be obtained with higher production efficiency. Specifically, a single crystal gallium nitride whose thickness in the m-axis direction is preferably 100 µm or more, more preferably 500 µm or more, still more preferably 1 mm or more, can be obtained.

The single crystal nitride produced by the production method of the present invention may be used as it is or may be processed and then used.

### (Wafer)

A wafer (semiconductor substrate) having an arbitrary crystal orientation can be obtained by cutting out from the single crystal nitride of the present invention in a desired direction. This enables obtaining a wafer having a polar face such as C plane or a nonpolar face such as M plane. In particular, when a nitride semiconductor crystal having a large-diameter C plane is produced by the production method of the present invention, a large-diameter C-pJ.ane wafer can be obtained by cutting out in a direction perpendicular to the c-axis. Also, when a nitride semiconductor having a thick and large-diameter M plane is produced by the production method of the present invention, a large-diameter M-plane wafer can be obtained by cutting out in a direction perpendicular to the m-axis. Such a wafer also has a uniform and high-quality property. That is, according to the present invention, a uniform and high-quality wafer can be obtained as compared with an M-plane wafer cut out from a bulk single crystal gallium nitride obtained by growing the crystal in the c-axis direction in accordance with a conventional method. Furthermore, an epitaxial wafer can be obtained by using the thus-obtained wafer of the present invention as a substrate and performing desired epitaxial growth thereon.

### (Device)

The single crystal nitride or wafer of the present invention is suitably used for the application to a device, that is, a light-emitting device, an electronic device or the like. Examples of the light-emitting device in which the single crystal nitride or wafer of the present invention is used include a light-emitting diode, a laser diode, and a light-emitting device combining such a diode with a phosphor. Examples of the electronic device in which the single crystal nitride or wafer of the present invention is used include a high-frequency device and a high-breakdown voltage high-output device. Examples of the high-frequency device include a transistor (HEMT, HBT), and examples of the high-breakdown voltage high-output device include a thyrister (IGBT). The single crystal nitride or wafer of the present invention has a uniform and high-quality property and therefore, is suitable for all of those applications. Above all, this single crystal nitride or wafer is suitable for the application to an electronic device requiring high uniformity in particular.

### EXAMPLES

The characteristic features of the present invention are described in greater detail below by referring to Examples and Comparative Examples. The materials, amounts used, ratios, processing contents, processing procedures and the like set forth in the following Examples can be appropriately changed without departing from the purport of the present invention. Accordingly, the scope of the present invention should not be construed as being limited to specific examples described below.

### (Example 1)

Crystal growth was performed using an apparatus shown in Fig. 2.
Using a platinum-lined autoclave 3 (made of Inconel 625, about 30 ml) with the inside dimension having a diameter of 16 mm and a length of 160 mm, 7.4 g of HVPE-grown GaN as a raw material 9 was placed in a raw material filling part 5 of the autoclave, and 1.57 g of fully dried powder NH₄Cl (purity: 99.99%) as a mineralizer was further filled thereon.

A baffle plate 6 was then set in the position at 80 mm from the bottom, a GaN seed was disposed in the crystal growth part 4 above the plate and after quickly closing an autoclave cover equipped with a valve, the autoclave 3 was weighed. The GaN seed 10 used here is a seed having a 5 mm-square C plane with the thickness in the c-axis direction being 500 µm, in which one side face is an M plane produced by cleavage. Subsequently, a channel 11 was operated to communicate with a vacuum pump through a valve 1 attached to the autoclave, and the inside of the autoclave 3 was vacuum-deaerated by opening the valve 1. Thereafter, while maintaining the vacuum state, the autoclave 3 was cooled by a dry ice-methanol solvent and the valve 1 was once closed. After operating the channel to communicate with an NH₃ cylinder, the valve 1 was again opened, and NH₃ was continuously filled in the autoclave 3 without exposure to outer air. Based on the flow rate control, NH₃ was filled as a liquid corresponding to about 65% of the cavity part of the autoclave (in terms of NH₃ density at -33°C) and then, the valve 1 was again closed. The temperature of the autoclave 3 was returned to room temperature and after thoroughly drying the outer surface, the increase by NH₃ filled was weighed.

Subsequently, the autoclave 3 was housed in an electric furnace 7 composed of a heater bi-divided into upper and lower parts. The temperature was raised over 6 hours while creating a temperature difference such that the temperature on the bottom outer face of the autoclave became 475°C and the temperature on the top outer face became 425°C, and after the temperature on the bottom outer face of the autoclave reached 475°C and the temperature on the top outer face reached 425°C, the autoclave was further kept at these temperatures for 96 hours. The pressure in the autoclave 3 was about 120 MPa. Also, the temperature width during the keeping was ±5°C or less. Thereafter, the temperature was lowered over about 9 hours until the temperature on the bottom outer face of the autoclave 3 became 50°C, heating by the heater was then stopped, and the autoclave was allowed to naturally cool in the electric furnace 7. After confirming that the temperature on the bottom outer face of the autoclave 3 dropped to almost room temperature, the valve 1 attached to the autoclave was opened to remove NH₃ in the autoclave 3, and the autoclave 3 was then weighed to confirm the discharge of NH₃. Furthermore, the valve 1 was once closed and operated to communicate with a vacuum pump, and the valve 1 was again opened to almost completely remove NH₃ in the autoclave 3.

Subsequently, the autoclave cover was opened and when the inside was confirmed, a GaN crystal was grown to a thickness of 50 µm on the C plane of the seed and to a thickness of 82 µm on the M plane, and the growth rates were 12.5 µm/day and 20.5 µm/day, respectively. When the GaN crystal grown on the seed surface was taken out, and the crystal face state was observed by SEM (scanning electron microscope), a needle crystal, a grain aggregate and the like were not observed. Furthermore, the measurement by X-ray diffraction revealed that the crystal form was hexagonal and as for the growth orientation, the crystal was, similarly to the seed, oriented in the c-axis on the C plane and in the m-axis on the M plane.

### (Examples 2 to 7 and Comparative Examples 1 and 2)

Growth of a GaN crystal was performed in the same manner as in Example 1 except that in Example 1, the crystal growth conditions and the kind and amount of the mineralizer used were changed as shown in Table 1 (Examples 2 to 4, 6 and 7 and Comparative Example 1). In Example 5, growth of a GaN crystal was performed in the same manner as in Example 2 except for using a seed having an M plane produced not by cleavage but by slicing. In Comparative Example 2, the crystal was the one described in a known publication (Journal of Crystal Growth, 287, 376-380 (2006)).

In Examples 2 to 7, when the GaN crystal grown on the seed surface was taken out, and the crystal face state was observed by SEM (scanning electron microscope) , a needle crystal, a grain aggregate and the like were not observed, similarly to Example 1. Furthermore, the measurement by X-ray diffraction revealed that the crystal form was hexagonal and as for the growth orientation, the crystal was, similarly to the seed, oriented in the c-axis on the C plane and in the m-axis on the M plane. Also in Comparative Examples 1 and 2, the crystal was oriented in the c-axis on the C plane and in the m-axis on the M plane.

### (Evaluation)

The GaN crystals of Examples 2 to 7 and Comparative Example 1 and 2 were measured for the growth rate in the m-axis direction and the growth rate in the c-axis direction. In the growth measurement, the growth amount in the m-axis direction of the crystal obtained and the growth amount in the c-axis direction were measured and each was divided by the crystal growth time. As for Comparative Example 2, the growth amount was obtained from the photograph described in the known publication (Journal of Crystal Growth, 287, 376-380 (2006)) and divided by the crystal growth time to determine the growth rate. The results are shown in Table 1.

**Table 1**

| | Crystal Growth Conditions | | | Kind and Amount of Mineralizer used | | | Growth Rate of Single Crystal | | Ratio of Crystal Growth Rates |
|---|---|---|---|---|---|---|---|---|---|
| | Temperature (°C) | Pressure (MPa) | Time (hr) | NH₄CL (g) | NH₄Br (g) | MgCL₂ (g) | c-Axis Direction (µm/day) | m-Axis Direction (µm/day) | m-Axis/c-Axis |
| Example 1 | 425 | 120 | 96 | 1.57 | 0 | 0 | 12.5 | 20.5 | 1.64 |
| Example 2 | 375 | 95 | 96 | 1.57 | 0 | 0 | 6-2 | 14.9 | 2.40 |
| Example 3 | 375 | 95 | 96 | 1.41 | 0-29 | 0 | 9.3 | 21-2 | 2.28 |
| Example 4 | 425 | 122 | 96 | 1.47 | 0.23 | 0 | 17-1 | 27-5 | 1.61 |
| Example 5 | 375 | 95 | 96 | 1.57 | 0 | 0 | 6.2 | 12-8 | 2-07 |
| Example 6 | 425 | 120 | 96 | 1.57 | 0 | 0.17 | 2.0 | 7.1 | 3.55 |
| Example 7 | 460 | 145 | 192 | 0.26 | 0 | 0.045 | 5.0 | 11.1 | 2.20 |
| Comparative Example 1 | 550 | 170 | 96 | 1.60 | 0 | 0 | 20.0 | 18.2 | 0.91 |
| Comparative Example 2 | >500 | 100-300 | 480 | KNH₂ | | | 34.3 | (32) | (0.93) |

As apparent from the results in Table 1, in Examples 1 to 7, the crystal could be grown on the seed at as high a crystal growth rate in the m-axis direction as 1.5 times or more the crystal growth rate in the c-axis direction. Particularly, in Examples 2, 3 and 5 to 7, the crystal could be grown on the seed at as high a crystal growth rate in the m-axis direction as two times or more the crystal growth rate in the c-axis direction. On the other hand, in Comparative Examples 1 and 2, the crystal growth rate in the m-axis direction is lower than the crystal growth rate in the c-axis direction.

As apparent from comparison between Example 1 and Example 4 in Table 1 and comparison between Example 2 and Example 3 in Table 1, the crystal growth rate can be increased when NH₄Cl and NH₄Br are used in combination, as compared with the case of using only NH₄Cl as a mineralizer. In Examples 1 and 4, the ratio of the dissolved amount to the charged amount of the raw material (dissolved amount/charged amount × 100) was determined and found to be 68% in Example 1 and 91% in Example 4. Here, the dissolved amount was determined by subtracting the residual raw material amount after growth from the charged amount. These results indicate that when NH₄Br is used in combination as a mineralizer in addition to NH₄Cl, the dissolved amount is increased and in turn, the crystal growth rate becomes high.

As apparent from comparison between Example 1 and Example 6 in Table 1, when MgCl₂ is further used in combination as a mineralizer in addition to NH₄Cl, the ratio (m-axis/c-axis) of the crystal growth rate in the m-axis direction to the crystal growth rate in the c-axis direction can be more increased. Also, as in Example 7, when the crystal growth conditions in using NH₄Cl and MgCl₂ in combination are adjusted, the crystal growth rate can be made high as compared with Example 6.

As apparent from comparison between Example 2 and Example 5 in Table 1, when the crystal growth is performed using a seed having an M plane produced by cleavage instead of a seed having an M plane produced by slicing, the growth rate in the m-axis direction can be increased. This indicates that the effects of the present invention can be more successfully obtained by performing the crystal growth with use of an M plane produced by cleavage.

### INDUSTRIAL APPLICABILITY

According to the present invention, the crystal growth in the m-axis direction can be increased by controlling the anisotropy in the growth rate of an ammonothermal method. Therefore, a nitride semiconductor having a large-diameter C plane or a nitride semiconductor thick in the m-axis direction can be efficiently and simply produced. Also, the single crystal nitride produced is homogeneous and excellent in the quality. By virtue of this property, the wafer or device of the present invention using such an excellent single crystal nitride exhibits high performance. Accordingly, the present invention is useful in industry, and its industrial applicability is very high.

While the invention has been described in detail and with reference to specific embodiments thereof, it will be apparent to one skilled in the art that various changes and modifications can be made therein without departing from the spirit and scope of the invention. This application is based on Japanese Patent Application (Patent Application No. 2006-280940) filed on October 16, 2006, the entirety of which is incorporated herein by reference.

## Claims

1. A method for producing a nitride semiconductor, comprising controlling temperature and pressure in a reaction vessel containing a seed having a hexagonal crystal structure, a nitrogen element-containing solvent, a raw material substance containing a metal element of Group 13 of the Periodic Table, and a mineralizer so as to put said solvent into a supercritical state and/or a subcritical state and thereby ammonothermally grow a nitride semiconductor crystal on the surface of said seed, wherein
the crystal growth rate in the m-axis direction on said seed is 1.5 times or more the crystal growth rate in the c-axis direction on said seed.

2. The method for producing a nitride semiconductor according to claim 1, wherein the crystal growth rate in the m-axis direction on said seed is 2.0 times or more the crystal growth rate in the c-axis direction on said seed.

3. The method for producing a nitride semiconductor according to claim 1 or 2, wherein said temperature is from 250 to 490°C.

4. The method for producing a nitride semiconductor according to any one of claims 1 to 3, wherein said pressure is from 60 to 160 MPa.

5. The method for producing a nitride semiconductor according to any one of claims 1 to 4, wherein said nitride semiconductor is a gallium-containing nitride semiconductor.

6. The method for producing a nitride semiconductor according to any one of claims 1 to 5, wherein said mineralizer contains an acidic mineralizer.

7. The method for producing a nitride semiconductor according to claim 6, wherein said acidic mineralizer contains an ammonium halide.

8. The method for producing a nitride semiconductor according to any one of claims 1 to 7, wherein said mineralizer contains a mineralizer containing an alkali metal element or an alkaline earth metal element.

9. The method for producing a nitride semiconductor according to claim 8, wherein said mineralizer containing an alkali metal element or an alkaline earth metal element contains a magnesium halide and/or a calcium halide.

10. The method for producing a nitride semiconductor according to any one of claims 1 to 9, wherein a plurality of chemical species are mixed as said mineralizer.

11. The method for producing a nitride semiconductor according to any one of claims 1 to 10, wherein a seed having a hexagonal crystal structure with the area of an M plane being larger than the area of a C plane is used as said seed.

12. The method for producing a nitride semiconductor according to any one of claims 1 to 11, wherein a seed having a cleavage plane is used as said seed and a nitride semiconductor is ammonothermally grown on the cleavage plane.

13. A method for producing a nitride semiconductor, comprising controlling temperature and pressure in a reaction vessel containing a seed having a hexagonal crystal structure, a nitrogen element-containing solvent, a raw material substance containing a metal element of Group 13 of the Periodic Table, and a mineralizer composed of a plurality of chemical species, so as to put said solvent into a supercritical state and/or a subcritical state and thereby ammonothermally grow a nitride semiconductor crystal on the surface of said seed.

14. The method for producing a nitride semiconductor according to claim 13, wherein said temperature is from 250 to 490°C.

15. The method for producing a nitride semiconductor according to claim 13 or 14, wherein said pressure is from 60 to 160 MPa.

16. The method for producing a nitride semiconductor according to any one of claims 13 to 15, wherein said nitride semiconductor is a gallium-containing nitride semiconductor.

17. The method for producing a nitride semiconductor according to any one of claims 13 to 16, wherein said mineralizer is an acidic mineralizer.

18. The method for producing a nitride semiconductor according to claim 17, wherein said acidic mineralizer contains an ammonium halide.

19. The method for producing a nitride semiconductor according to any one of claims 13 to 18, wherein said mineralizer contains a mineralizer containing an alkali metal element or an alkaline earth metal element.

20. The method for producing a nitride semiconductor according to claim 19, wherein said mineralizer containing an alkali metal element or an alkaline earth metal element contains a magnesium halide and/or a calcium halide.

21. The method for producing a nitride semiconductor according to any one of claims 13 to 20, wherein two or more kinds of chemical species are mixed as said mineralizer.

22. The method for producing a nitride semiconductor according to any one of claims 13 to 21, wherein a seed having a hexagonal crystal structure with the area of an M plane being larger than the area of a C plane is used as said seed.

23. The method for producing a nitride semiconductor according to any one of claims 13 to 22, wherein a seed having a cleavage plane is used as said seed and a nitride semiconductor is ammonothermally grown on the cleavage plane.

24. A growth rate increasing agent, which is a crystal growth rate increasing agent used when controlling the temperature and pressure in a reaction vessel containing a seed having a hexagonal crystal structure, a nitrogen element-containing solvent, a raw material substance containing a metal element of Group 13 of the Periodic Table, and a mineralizer so as to put said solvent into a supercritical state and/or a subcritical state and thereby ammonothermally grow a nitride semiconductor crystal on the surface of said seed, the growth rate increasing agent containing a mineralizer composed of a plurality of chemical species.

25. The crystal growth rate increasing agent according to claim 24, wherein said temperature is from 250 to 490°C.

26. The crystal growth rate increasing agent according to claim 24 or 25, wherein said pressure is from 60 to 160 MPa.

27. A single crystal nitride produced by the method of any one of claims 1 to 23.

28. The single crystal nitride according to claim 27, wherein the surface area of an M plane is larger than the surface area of a C plane.

29. A wafer cut out from the single crystal nitride of claim 27 or 28.

30. A device using the single crystal nitride of claim 27 or 28 or the wafer of claim 29.
